# EUROPEAN PATENT APPLICATION

(11) **EP 1 103 995 A1**
(43) Date of publication of application: **30.05.2001**
(21) Application number: 00937171.7
(22) Date of filing: 07.06.2000
(51) Int. Cl.: H01G 4/228, H05K 3/34, H01C 17/28, H01F 27/29, H01F 41/04, B23K 35/26

(54) **ELECTRONIC COMPONENT, AND ELECTRONIC APPARATUS IN WHICH THE ELECTRONIC COMPONENT IS MOUNTED AND ITS MANUFACTURING METHOD**

(30) Priority: 09.06.1999 JP 16190499
(71) Applicant: MATSUSHITA ELECTRIC INDUSTRIAL CO., LTD., Kadoma-shi, Osaka 571-8501 (JP)
(72) Inventor: NAKAMURA, Tsuneshi, Hirakata-shi, Osaka 573-0084 (JP); YOSHIDA, Akio, Takatsuki-shi, Osaka 569-0097 (JP); USHIO, Noriki, Suita-shi, Osaka 565-0848 (JP); KURIBAYASHI, Takashi, Fushimi-ku, Kyoto-shi, Kyoto 612-8243 (JP); YAMAZOE, Toshihiro, Nishinomiya-shi, Hyogo 662-0823 (JP); KAKINOKI, Yoshiaki, Uji-shi, Kyoto 611-0021 (JP)
(74) Representative: Grünecker, Kinkeldey, Stockmair & Schwanhäusser Anwaltssozietät
(86) International application number: JP0003682
(87) International publication number: WO0075940

(57) **Abstract**

An electronic component, which is friendly to the environment of the earth and has high reliability in a joint between an external terminal in the electronic component and a circuit pattern on a printed circuit board, is provided. Further, an electronic apparatus on which the electronic component is mounted and a manufacturing method of the electronic apparatus are provided. The electronic component of the present invention has a wire having a Sn-Cu alloy layer as the outermost layer or the external terminal with the Sn-Cu alloy layer as the outermost layer. In the manufacturing method, the electronic component is electrically coupled to a desired circuit pattern on the printed circuit board by the Sn-Cu alloy layer.

## Description

### FIELD OF THE INVENTION

The present invention relates to an electronic component, an electronic apparatus mounted the electronic component and a method of manufacturing the electronic apparatus. The invention relates particularly to the electronic component, the electronic apparatus mounted the electronic component and the method for manufacturing the apparatus to address problems of the environment on the earth.

### BACKGROUND OF THE INVENTION

Recently, for improving the pollution of the environment on the earth, a big effort has been actively made for not using hazardous substance such as lead in electronic apparatuses such as television receivers or video tape recorders.

Under this situation, an Sn-Bi, Sn-Ag, Sn-Zn or Sn-Cu based-lead-free solder is actively in research and development instead of a conventional Sn-Pb based eutectic solder widely-used in assembly of the electronic apparatuses. In these lead free solders, the Sn-Cu based-eutectic ally is especially noted as a solder used in a flow-infiltration soldering apparatus. The Sn-Cu based-eutectic alloy can improve mechanical and electrical characteristics properties in a solder joint as well as economical situation.

On the other hand, in the soldering by a flow-infiltration method using the Sn-Cu based-eutectic alloy, an external terminal in the electronic component placed on a printed circuit board is Sn-Pb plated or Sn plated in the surface of the terminal. An electronic component plated with Sn-Bi or Sn-Ag is considered to produce a lead-free external terminal.

When different metal such as Pb, Bi, Ag, or Zn is mixed into the melted Sn-Cu eutectic alloy and the mixture is left for a long time, a circuit pattern on the printed circuit board is peel off a Sn-Cu alloy layer. Accordingly, reliability of the apparatus lowered. The peeling is called "lift-off'.

In the electronic component of which external terminal is plated with Sn containing no other metals, whiskers may be formed depending on a usage condition, and furthermore, a circuit may short.

The present invention can address the problems and provide the electronic component which is friendly to the environment of the earth and highly-reliable in a joint between the external terminal of the electronic component and the circuit pattern on the printed circuit board.

### DISCLOSURE OF THE INVENTION

In the present invention, Sn-Cu alloy layer is disposed over the surface of an external terminal in an electronic component. The Sn-Cu alloy layer contains 0.5-3% of copper. An electronic apparatus of the present invention employs the electronic component of the present invention. The electronic component is coupled to an circuit pattern with a Sn-Cu eutectic alloy.

### BRIEF DESCRIPTION OF THE DRAWINGS

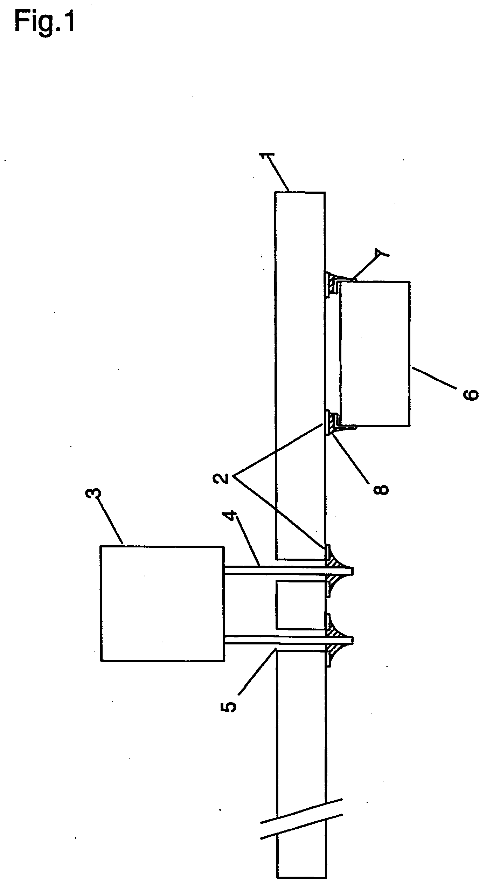

Fig. 1 is a cross sectional view of an electronic apparatus according to an exemplary embodiment of the present invention.

### DESCRIPTION OF THE PREFERRED EMBODIMENT

An electronic apparatus in the embodiment of the present invention will be described with referring to a drawing hereinafter.

Fig 1 is a cross sectional view of the electronic apparatus according to the embodiment of the present invention.

In Fig. 1, circuit pattern 2 made of a copper foil etched with a desired pattern is formed over printed circuit board 1 having a paper phenol substrate, a glass epoxy substrate or the like as a base material. Printed circuit board 1 includes through-hole 5 where wire 4 is inserted. Wire 4 is an external terminal of first electronic component 3 such as a resistor, a capacitor or a inductor.

Wire 4 includes a metal wire made of iron or copper over which a Sn-Cu alloy layer and a plating metal layer made of nickel or copper are formed. The Sn-Cu alloy layer is formed over the metal wire via the plating metal layer. External terminal 7 of wire-less and surface-mount-type second electronic component 6, such as a resistor, a capacitor or a inductor, includes the Sn-Cu alloy layer as an outermost layer over the surface of sintered silver and glass via a barrier metal layer made of nickel or the like.

These surface alloy layers can be formed with various methods. In general, plating method has advantages in the device assembly and cost. Plating can control easily the composition of the alloy of the surface layer.

In the embodiment, the Sn-Cu alloy in the outermost layer of wire 4 and external terminal 7 contains 0.5-3% of Cu.

Table 1 shows a relation among a rate of forming whiskers, solder-affinity, and a Cu concentration in the Sn-Cu alloy. The rate of forming whiskers is determined as following. Wire 4 plated with Sn-Cu alloy is folded 180 degree and left at 60°C in an atmosphere of 95% RH for 1000 hours, and then, a surface at a folded portion is observed. The "x" shows that an Sn needle-like protrusion longer than 50µm is observed. The circle denotes the other situation.

Solder-affinity is determined by measuring a zero-crossing time when Sn-Cu alloy-plated wire 4 and the second electronic component are left at 60°C in an atmosphere of 95% RH for 168 hours and then immersed in a soldering bath with dissolved Sn-Cu alloy. The "x" shows that the zero crossing time is not less than 3 seconds, and the circle shows the other result.

**Table 1**

| | | | | | | |
|---|---|---|---|---|---|---|
| Cu-Concentration in Alloy (%) | 0 | 0.3 | 0.5 | 1.0 | 3.0 | 5.0 |
| Rate of Forming Whiskers | 5/10 | 3/10 | 0/10 | 0/10 | 0/10 | 0/10 |
| Solder-affinity | ○ | ○ | ○ | ○ | ○ | X |

### Condition of measurement;

Temperature of Sn-Cu soldering: 255°C
Velocity of immersion: 5mm/sec (1mm/sec)
Depth of immersion: 2mm (0.1mm)
Flux: rosin based active flux
Measuring device: SAT-5000 (REHSCA Company, Ltd.)

As evident from table 1, in the case that the outermost layer of wire 4 or external terminal 7 in the second electronic component is made of Sn-Cu alloy and the Sn-Cu alloy contains 0.5-3% of Cu, whiskers are not formed, and solder-affinity is favorable.

Moreover, wire 4 of first electronic component 3 and external terminal 7 of second component 6 are electrically coupled to circuit pattern 2 on printed circuit board 1 respectively via Sn-Cu eutectic alloy layer. When soldering, wire 4 or external terminal 7 is immersed in the melted Sn-Cu eutectic alloy.

A manufacturing method of the electronic apparatus as shown above will be described.

First, circuit pattern 2 made by etching a copper foil into desired pattern is formed over printed circuit board 1 having through-hole 5.

Then, wire 4 having the Sn-Cu alloy layer in first electronic component 3 is inserted into through-hole 5, and second electronic component 6 having external terminal 7 with Sn-Cu alloy layer is fixed by an adhesive if necessary,

Then, wire 4 of first electronic component 3 and external terminal 7 of second electronic component 6 are electrically jointed to circuit pattern 2 on printed circuit board 1 with the flow-infiltration method using molted lead-free Sn-Cu eutectic alloy. They are jointed by Sn-Cu eutectic alloy layer 8. Because wire 4 of first electronic component 3 and external terminal 7 of second electronic component 6 are coated with Sn-Cu alloy layer of the embodiment, different metals do not exist between Sn-Cu eutectic alloy layer 8 for joint and wire 4 or external terminal 7. The connection between the electronic component and circuit pattern is thus stable.

In the above description, the method of manufacturing the electronic apparatus by using the flow-infiltration method for soldering is described. Furthermore, when mounted electronic components are all surface-mounted type and also the surface of the external terminal thereof is coated with Sn-CU alloy layer with a composition of the alloy of the present invention, the flow soldering using Sn-Cu alloy can be used.

And also, in the above description, Sn-Cu eutectic alloy is used, however, when manufacturing the electronic apparatuses, Sn-Cu alloys of no-eutectic type also can be used depending on conditions.

### INDUSTRIAL AVAILABILITY

As shown above, the electronic component of the present invention includes a Sn-Cu alloy layer having a specified Cu-concentration over the surface of an external terminal. Therefore, when the external terminal and a circuit pattern on a printed circuit board are jointed with a flow-infiltration method using a molted Sn-Cu alloy, different metals do not solve out into the Sn-Cu alloy. Consequently, because different metal do not exist in the jointed portion, a stable joint is provided, and reliability of the electronic apparatus is improved. The electronic apparatus of the present invention, which has a Sn-Cu alloy layer with the most favorable Cu-concentration over the surface of its external terminal, is also reliable for preservation.

According to the present invention, without using metal affecting the environment of the earth such as lead, highly-reliable electronic apparatus can be produced with great industrial availability.

## Claims

1. An electronic component comprising:
an external terminal; and
an Sn-Cu alloy layer over a surface of said external terminal

2. The electronic component according to claim 1, wherein said Sn-Cu alloy layer contains 0.5-3% of Cu.

3. An electronic apparatus comprising:
a printed circuit board; and
an electronic component comprising:
an external terminal; and
an Sn-Cu alloy layer over a surface of said external terminal,
wherein said external terminal of said electronic component and a circuit pattern on said printed circuit board are electrically jointed with Sn-Cu based alloy containing no lead.

4. The electronic apparatus according to claim 3, wherein said Sn-Cu alloy layer over the surface of said external terminal contains 0.5-3% of Cu.

5. The electronic apparatus according to claim 3, wherein said Sn-Cu base alloy jointing said external terminal of said electronic component and the circuit pattern on said printed circuit board is Sn-Cu eutectic alloy.

6. A manufacturing method of manufacturing an electronic apparatus comprising the steps of:
forming an Sn-Cu alloy layer over a surface of an external terminal of an electronic component;
mounting the electronic component on a printed circuit board; and
electrically jointing the external terminal of the electronic component and a circuit pattern on the printed circuit board with Sn-Cu based alloy containing no lead.

7. The manufacturing method according to claim 6, wherein the Sn-Cu alloy layer over the surface of the external terminal contains 0.5-3% of Cu.

8. The manufacturing method according to claim 6, wherein the Sn-Cu based alloy jointing the external terminal of the electronic component and the circuit pattern on the printed circuit board is Sn-Cu eutectic alloy.
